# EUROPÄISCHE PATENTSCHRIFT

(11) **EP 1 723 672 B1**
(45) Veröffentlichungstag und Bekanntmachung des Hinweises auf die Patenterteilung: **13.06.2007**
(21) Anmeldenummer: 05701050.6
(22) Anmeldetag: 19.01.2005
(51) Int. Cl.: H01L 27/02

(54) **Halbleiterbauelement mit integrierter Zener-Diode und Verfahren zur Herstellung**
Semi-conductor element comprising an integrated Zener diode and method for the production thereof
Composant semiconducteur comportant une diode Zener intégrée et procédé de fabrication

(30) Priorität: 10.03.2004 DE 102004011703
(43) Veröffentlichungstag der Anmeldung: 22.11.2006
(73) Patentinhaber: austriamicrosystems AG, 8141 Unterpremstätten (AT)
(72) Erfinder: ENICHLMAIR, Hubert, A-8042 Graz (AT)
(74) Vertreter: Epping, Wilhelm
(86) Internationale Anmeldenummer: PCT/EP2005/000499
(87) Internationale Veröffentlichungsnummer: WO 2005/088718

(56) Entgegenhaltungen:
- EP-A- 0 318 297
- EP-A- 0 414 499
- US-A1- 2002 030 231

## Beschreibung

Zener-Dioden sind pn-Dioden, die bei einer Verschaltung in Sperrrichtung bei einer bestimmten Spannung, der sogenannten Zener-Spannung, schlagartig einen Durchbruch aufweisen. Sie werden daher üblicherweise als spannungsbegrenzende Bauelemente und insbesondere zum Schutz von Halbleiterbauelementen gegenüber Überspannungen eingesetzt.

Elektrostatische Aufladung und in der Folge elektrostatische Entladungsphänomene (ESD) führen zu kurzen Strompulsen von hoher Spannung und moderater Stromstärke. Diese ESD-Effekte sind in integrierten Schaltungen stets ein Problem und für komplementäre Metalloxidhalbleiter (CMOS-Bauelemente) besonders schädlich. CMOS-Strukturen haben ein nur dünnes Gate-Oxid und kurze leitende Kanäle, die nur wenigen 10 V widerstehen können. Eine ESD-Entladung, deren Puls durch eine CMOS-Struktur führt, kann das Gate-Oxid aufbrechen und in der Folge durchbrennen. Bei dickeren Oxidschichten können auch Latch-Up-Effekte auftreten. In jedem Fall führt dies zu einer vorübergehenden Funktionsstörung und zumeist auch zum Ausfall des Bauelements.

Zur Vermeidung von ESD-Problemen und anderen Überspannungen werden daher regelmäßig Ein- und Ausgang der Bauelemente mit Dioden überbrückt, die Überspannungen für das Bauelement ungefährlich über einen Kurzschluss ableiten können.

Aus der US 5,821,572 B1 und der US-A-2002/0030231 ist ein integriertes Halbleiterbauelement bekannt, welches einen Bipolartransistor, eine CMOS-Struktur und eine die Eingänge überbrückende integrierte Zener-Diode aufweist. Zur Herstellung in einem BICMOS-Prozess, der für CMOS und Bipolarstrukturen kombatibel ist, werden dabei in der p-dotierten Wanne für die Basis des npn-Bipolartransistors n- und p-dotierte Gebiete zur Erzeugung eines pn-Übergangs für die Zener-Diode erzeugt. Die Herstellung der. Zener-Dioden ist in den BICMOS-Prozess integriert.

Aufgabe der vorliegenden Erfindung ist es, ein verbessertes Halbleiterbauelement mit voll integrierter Zener-Diode anzugeben, welches einfach, integriert und bezüglich der Zenerspannung gut kontrollierbar herzustellen ist.

Diese Aufgabe wird erfindungsgemäß durch ein Halbleiterbauelement nach Anspruch 1 gelöst. Vorteilhafte Ausgestaltungen der Erfindung sowie ein Verfahren zur Herstellung des Halbleiterbauelements gehen aus weiteren Ansprüchen hervor.

Ein erfindungsgemäßes Halbleiterbauelement weist eine integrierte Zener-Diode mit neuer Struktur auf. In einem Halbleitersubstrat ist dazu ein vergrabenes n-dotiertes Gebiet vorgesehen. Zwischen der Oberfläche des Substrats und dem vergrabenen Gebiet sind zumindest zwei n-dotierte Zonen angeordnet, die elektrisch leitfähige Pfade von der Oberfläche zu diesem vergrabenen Gebiet schaffen. Innerhalb der ersten n-dotierten Zone in einem der Oberfläche benachbarten Bereich ist diese durch eine p-Dotierung gegendotiert. Auf der Oberfläche des Substrats ist über dem p-dotierten Gebiet ein erster Kontakt und über der zweiten n-dotierten Zone ein zweiter Kontakt ausgebildet, die die elektrischen Anschlüsse der Zener-Diode bilden.

Die Zener-Diode weist eine vertikale Struktur auf, deren Halbleiterübergang allein durch das Dotierungsprofil von n-dotierter Zone und p-dotiertem Gebiet bestimmt und infolgedessen ohne aufwendige Strukturierung und Justierung exakt und gut kontrolliert eingestellt werden kann. Ebenso exakt kann die vom Dotierungsprofil abhängige Zener-Spannung eingestellt werden.

Der p/n-Übergang der Zener-Diode bzw. die dazu erforderlichen Dotier- und insbesondere Implantationsprozesse sind Standardverfahren eines BICMOS-Prozesses und werden daher integriert zusammen mit der Herstellung der entsprechenden bipolaren Transistorstrukturen und der CMOS-Strukturen durchgeführt werden. Es wird dazu weder eine separate Maske, noch ein separater Verfahrensschritt benötigt. Ein erfindungsgemäßes Bauelement ist daher kostengünstig herzustellen und weist eine gut kontrollierbare Zener-Spannung auf, die eine sichere Ableitung von Überspannungen im Halbleiterbauelement ermöglicht, und die eine Beschädigung von CMOS-Strukturen und anderen empfindlichen Teilen des Bauelements infolge von Überspannungen vermeidet.

In einer vorteilhaften geometrischen Ausgestaltung ist die erste n-dotierte Zone zentral angeordnet und ringförmig von der zweiten n-dotierten Zone umgeben, die konzentrisch zur zentralen ersten n-dotierten Zone angeordnet ist. Auf diese Weise wird eine Zener-Diodenstruktur erhalten, deren Anodenanschluss über das p-dotierte zentrale Gebiet eine hohe Stromdichte aufweist und dessen Kathode, die mit der zweiten n-dotierten Zone verbunden ist, niederohmig angeschlossen ist. Dies garantiert im Fall des Überschreitens der Zener-Spannung eine schnellen Ableitung der Überspannung. Dabei kann gezielt eine Degradierung des zentralen Kontakts herbeigeführt werden, die diesen Kontakt niederohmig macht, wobei man von einem Zener-Fuse spricht. Ein Zener-Fuse kann zur Herstellung von elektrisch programmierbaren Bauelementen genutzt werden, die sich gezielt durch Anlegen einer die Zenerspannung überschreitenden Spannung an die Zener-Diode programmieren lassen, wobei eine vorher nicht vorhandene niederohmige leitende Verbindungen geschaffen wird. Durch eine kontrollierte Zenerspannung wird die Degradierung reproduzierbar bzw. lässt sich genau einstellen.

Ein erfindungsgemäßes Halbleiterbauelement weist zumindest einen vertikal angeordneten Bipolartransistor auf. Dessen im Substrat angeordneter Kollektor ist über ein vergrabenes Gebiet mit einer n-Dotierung angeschlossen. Ein weiteres vergrabenes Gebiet gleicher Ausgestaltung bzw. gleicher Implantationstiefe und gleicher Dotierung dient auch zum Anschluss der Anode der Zener-Diode. In der BICMOS-Struktur kann daher dieser Prozess gleichzeitig zur Herstellung des Kollektoranschlusses sowie zur Herstellung des Anodenanschlusses der Zener-Diode genutzt werden.

Der Kollektoranschluss bzw. die Verbindung des vergrabenen Gebietes mit der Oberfläche über eine leitfähige n-dotierte Zone wird zusammen mit dem gleichartigen Anodenanschluss der Zener-Diode ausgebildet, der ebenfalls eine gegenüber der ersten n-dotierten Zone seitlich versetzte, n-dotierte zweite Zone aufweist, mit der das vergrabene Gebiet über einen leitfähigen Pfad mit der Oberfläche bzw. dem dort angeordneten Kontakt verbunden ist.

Des weiteren weist ein erfindungsgemäßes Bauelement eine CMOS-Struktur auf, deren p-Kanal Transistor p-dotierte Source/Drain-Gebiete besitzt, die im gleichen Schritt wie das p-dotierte zentrale Gebiet der Zener-Diode hergestellt werden und damit dieselbe Dotierstärke und Implantationstiefe aufweisen.

Vorzugsweise ist das vergrabene Gebiet mit Antimon dotiert. Dabei ist von Vorteil, dass die Antimon-Dotierung nur eine geringe Diffusionsneigung aufweist. Das vergrabene Gebiet kann daher mit eng begrenzter Dotierung bzw. mit steil ansteigendem Dotierungsprofil hergestellt werden. Dies ermöglicht einen sicheren Anschluss der Zener-Anode bzw. des Kollektors, ohne durch Diffusion in den Bereich des Halbleiterübergangs die Eigenschaften des pn-Übergangs der Zener-Diode oder des Kollektorbasisübergangs des Bipolartransistors zu beeinflussen oder unzulässig zu verändern.

Erste und zweite n-dotierte Zone sind ebenso wie der Kollektoranschluss mit Phosphor dotiert. Die Dotierung ist als sogenannter Kollektorsinker ausgebildet, bei dem eine Phosphordotierung mit hoher Energie implantiert und anschließend thermisch bis zum vergrabenen Gebiet eingetrieben wird.

Das p-dotierte Gebiet weist eine relativ zu den n-dotierten Zonen flache Dotierung mit hohem Dotierstoffgehalt auf, wobei bevorzugt Bor als p-Dotierstoff eingesetzt wird. Dies entspricht der im gleichen Verfahrensschritt hergestellten Bor-Dotierung der Source/Drain-Gebiete der CMOS-Struktur. Diese Dotierung wird mit niedriger Implantationsenergie aber sehr hoher Dosis durchgeführt, an die sich ein relativ kurzer thermischer Schritt zur Aktivierung der Dotierung anschließt.

Im folgenden wird die Erfindung und insbesondere das Verfahren zur Herstellung eines erfindungsgemäßen Halbleiterbauelements anhand von Ausführungsbeispielen und der dazugehörigen Figuren näher erläutert. Die Figuren sind zur besseren Verständlichkeit nur schematisch ausgeführt und nicht maßstabsgetreu. Gleiche Elemente sind mit gleichen Bezugszeichen bezeichnet.
- Figuren 1 bis 6: zeigen anhand schematischer Querschnitte das Bauelement während verschiedener Verfahrensstufen bei der Herstellung
- Figur 7: zeigt ein Bauelement in schematischer Draufsicht
- Figur 8: zeigt die Verteilung der unterschiedlichen Dotierstoffe anhand von Dotierstoffprofilen
- Figur 9: zeigt eine einfache schematische Verschaltung eines erfindungsgemäßen Bauelements mit integrierter Zener-Diode anhand eines Schaltbilds.

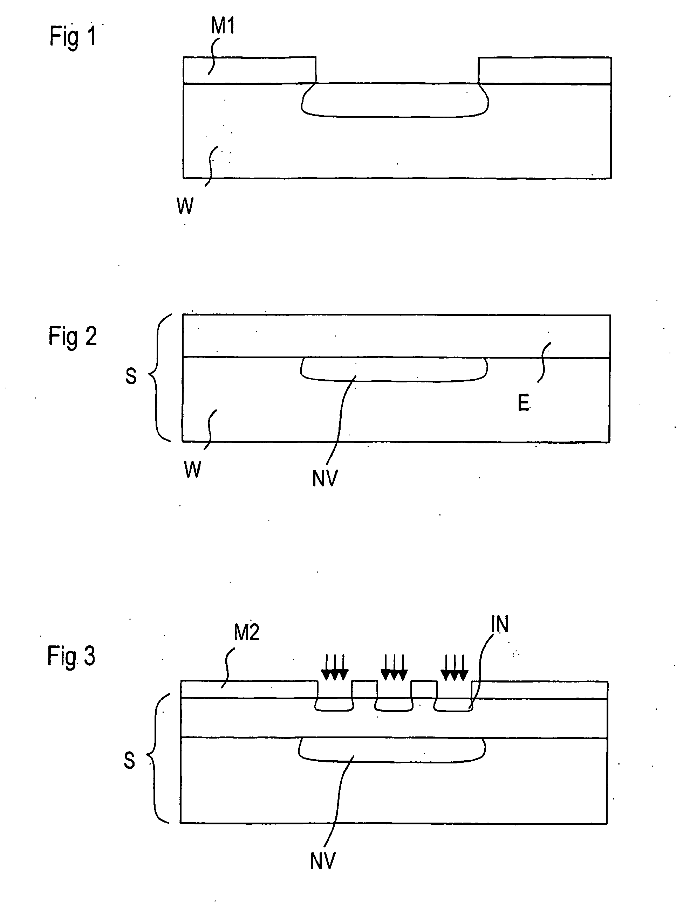

Ein erfindungsgemäßes Bauelement wird in einem integrierten Verfahren auf Waferebene gefertigt. Ausgangspunkt ist daher ein Halbleiterwafer W, insbesondere ein Siliziumwafer. Möglich sind jedoch auch Halbleiterlegierungen, beispielsweise SiGe mit bis zu 30 % Germaniumanteil für den Wafer zu verwenden. Beispielsweise wird ein Siliziumwafer verwendet, der eine schwache p-Dotierung von zirka 10¹⁶ cm⁻³ aufweist. Auf diesem Wafer wird eine erste Implantationsmaske M1 aufgebracht, um die vergrabenen Gebiete für die Bipolartransistoren und die zumindest eine Zener Diode an den gewünschten Stellen zu erzeugen. Die Maske kann aus Oxid und insbesondere aus Feldoxid bestehen. Für großflächige Abdeckungen sind auch Resistmasken geeignet. In die von der Maske ausgesparten Bereiche wird nun Antimon mit mittlerer Implantationsenergie in das Gebiet PV implantiert. Anschließend wird die Antimon-Dotierung thermisch aktiviert und eingetrieben. Figur 1 zeigt den Wafer im schematischen Querschnitt nach diesem Schritt.

Anschließend wird über dem Halbleiterwafer eine epitaktische Schicht E aufgewachsen, beispielsweise eine Siliziumschicht mit einer schwachen p-Grunddotierung von etwa 10¹⁵ cm⁻³. Die so erhaltene und in Figur 2 im schematischen Querschnitt dargestellte Anordnung zeigt das Halbleitersubstrat S, bei dem das Gebiet mit der Antimondotierung unterhalb der epitaktischen Schicht E liegt und nun ein vergrabenes Gebiet PV darstellt.

Auf dem Substrat wird im Laufe des BICMOS Prozesses eine zweite Implantationsmaske M2 erzeugt, die zumindest zwei räumlich voneinander getrennte Öffnungen über einem vergrabenen Gebiet PV aufweist. In die freiliegende Halbleiteroberfläche wird nun Phosphor mit hoher Implantationsenergie und hoher Dosis implantiert (siehe Pfeile) und so implantierte Gebiete IN erzeugt. Figur 3 zeigt die Anordnung während der Implantation im schematischen Querschnitt.

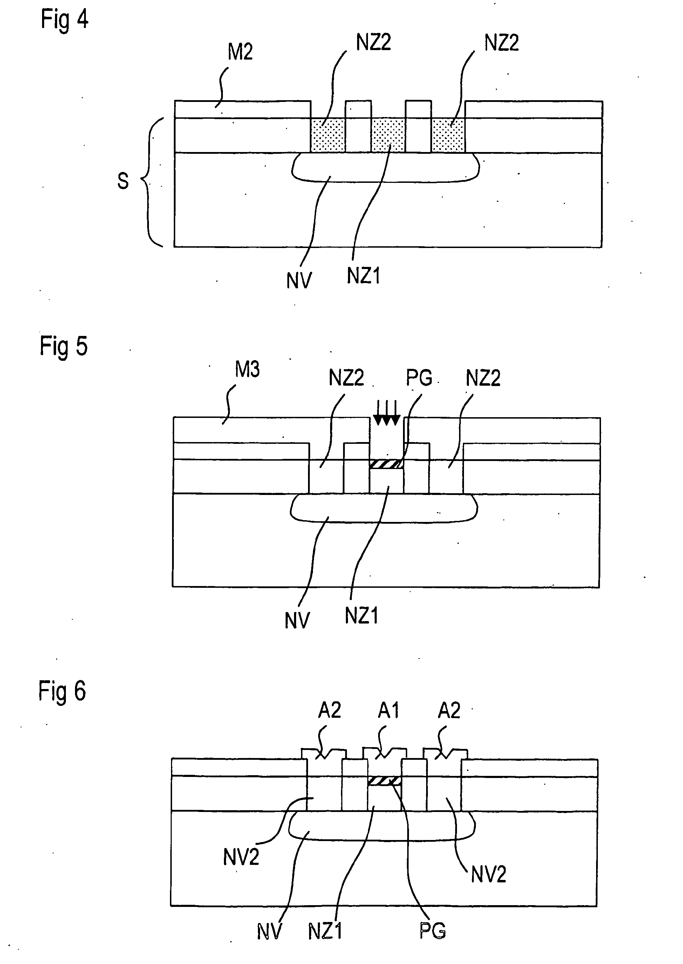

Anschließend wird der implantierte Phosphor in einem thermischen Schritt tiefer in das Substrat S eingetrieben, bis die n-dotierten Zonen NZ bis zum vergrabenen Gebiet PV diffundiert sind. Figur 4 zeigt die Anordnung nach der Herstellung der n-dotierten Zonen NZ. Dargestellt ist eine Ausführungsform, bei der eine erste n-dotierte Zone NZ1 zu zwei beabstandeten zweiten n-dotierten Zonen NZ2 benachbart ist, die alle Verbindung zum selben vergrabenen Gebiet PV aufweisen.

Die in Figur 3 dargestellte Phosphorimplantation über die Implantationsmaske M2 zur Herstellung der dotierten Zonen NZ wird gleichzeitig dazu verwendet, an anderer Stelle gleichzeitig eine gleichartige n-dotierte Zone bis zu einem anderen vergrabenen Gebiet für einen Kollektoranschluss für einen vertikalen Bipolartransistor zu erzeugen. Im Fall des Bipolartransistors dient das vergrabene Gebiet als Subkollektor. Die n-dotierten Zonen werden aufgrund ihrer Herstellung, die ein tiefes Eintreiben des Dotierstoffs beinhaltet, auch als n-Sinker bzw. im konkreten Fall als Kollektorsinker bezeichnet.

In einem nächsten Schritt wird eine dritte Implantationsmaske M3 erzeugt, die im Bereich der Zener-Diode eine Öffnung über der ersten n-dotierten Zone NZ1 frei lässt. Durch diese Maskenöffnung wird anschließend eine Bor-Implantation mit niedriger Implantationsenergie, aber hoher Dosis durchgeführt. Figur 5 zeigt diese Implantation anhand der Pfeile IP1, die zur Herstellung eines p-dotierten Gebietes PG führt. Anschließend wird die Bor-Dotierung aktiviert, beispielsweise durch einen kurzen thermischen Schritt bei zirka 1.000° für zirka 20 Sekunden.

Die Maske M3 und die darauffolgende Bor-Implantation wird gleichzeitig dazu verwendet, an anderer Stelle die Source/Drain-Gebiete für eine CMOS-Struktur zu erzeugen. Dazu weist die Maske M3 entsprechende weitere Öffnungen auf.

Im folgenden werden anhand von an sich bekannten Schritten die Anschlusskontakte für das p-dotierte Gebiet PG und die n-dotierten Zonen NZ2 hergestellt. Dazu wird beispielsweise in bekannter Weise über dem p-dotierten Gebiet PG eine p-Typ Kontaktplug-Implantation durchgeführt und ein Wolframsilizid als Anschlusskontakt A1 ausgebildet. In ähnlicher Weise werden Kontaktanschlüsse A2 zur zweiten n-dotierten Zone NZ2 hergestellt. Figur 6 zeigt die Anordnung mit den fertigen Anschlusskontakten A1, A2. Die Zener-Diode besteht nun aus dem pn-Übergang zwischen dem p-dotierten Gebiet PG und der zentralen n-dotierten Zone NZ1 darunter. Über das vergrabene Gebiet PV und die zweite n-dotierte Zone NZ2 erfolgt der elektrische Anschluss der Anode der Zener-Diode.

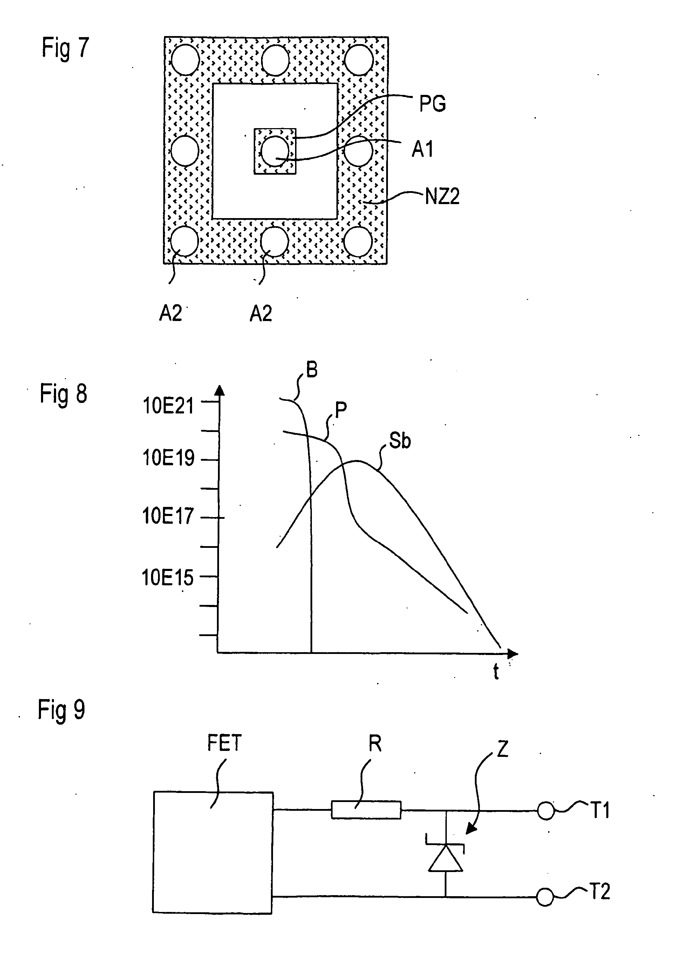

Figur 7 zeigt eine besonders vorteilhafte Ausgestaltung des über der ersten n-dotierten Zone NZ1 aufgebrachten p-dotierten Gebiets PG. Die erste n-dotierte Zone NZ1 wird ebenso wie das p-dotierte Gebiet PG in einem zentralen Bereich der Zener-Diode erzeugt. Die zweite n-dotierte Zone NZ2 umschließt dieses zentrale Gebiet im Abstand ringförmig. Auf diese Weise wird über den erhöhten Leiterquerschnitt der flächenmäßig relativ großen n-dotierten Zone NZ2 ein niederohmiger Anschluss der Anodenseite der Zener-Diode gewährleistet. In dieser Draufsicht sind auch schematisch die Anschlusskontakte A1, A2 dargestellt, wobei für die zweite n-dotierte Zone NZ2 eine Vielzahl von Anschlusskontakten A2 vorgesehen sein kann.

Figur 8 zeigt ein beispielhaftes Dotierprofil der Zener-Diode im Bereich des Halbleiterübergangs der Diode. Dabei ist über der Eindringtiefe t der Dotierstoffgehalt in logarithmischer Darstellung in Atomen/cm³ aufgetragen. Die dargestellten Kurven zeigen die Dotierstoffverteilung im fertigen Bauelements für Bor, Phosphor und Antimon in Abhängigkeit eines virtuellen Abstands von der Oberfläche des Substrats ohne definierten Nullpunkt.

Die höchste Dotierstoffkonzentration, und auch den steilsten Abfall und damit auch die kompakteste Dotierung ist die Bor-Dotierung B, die auch die geringste Eindringtiefe aufweist. Die Kurve P für die als Sinker hergestellte Phosphordotierung zeigt aufgrund des Diffusionsvorgangs einen flacheren Abfall und schneidet sich bei einer mittleren Dotierungsstärke mit dem Dotierungsprofil der Antimon-Dotierung Sd. Die Antimon-Dotierung weist ihr Maximum im Zentrum des vergrabenen Gebiets NV auf. Die resultierende wirksame Gesamtdotierung führt zu einem scharfen pn-Übergang ungefähr am Schnittpunkt der Linien für den Dotierstoffgehalt B und P. Das flache p-dotierte Gebiet mit der Bor-Dotierung B ist bezüglich der Eindringtiefe scharf begrenzt, kann über die Eintreibbedingungen gut kontrolliert werden und führt zu dem sauberen pn-Übergang. Die Lage des pn-Übergangs bzw. dessen Tiefe bestimmt wiederum die Höhe der Zener-Spannung, wobei die Zener-Spannung mit zunehmender Eindringtiefe der Bor-Dotierung B zunimmt. Ein erfindungsgemäßes Bauelement hat vorteilhaft Zenerdioden mit Zenerspannungen von typischerweise 2V.

Eine integriert hergestellte Zener-Diode wird im fertigen Halbleiterbauelement so mit den übrigen Halbleiterkomponenten und insbesondere mit den CMOS-Strukturen verschaltet, dass gefährdete Bauelementbereiche von der in Sperrrichtung geschalteten Zener-Diode überbrückt werden. Figur 9 zeigt in schematischer Darstellung eine CMOS-Struktur FET, die mit einem ersten und einem zweiten Anschluss T1, T2 über einen Widerstand R verbunden ist. Die Zener-Diode Z schafft in Sperrrichtung einen Kurzschluss zwischen T1 und T2. Dies führt dazu, dass beim Überschreiten der Zener-Spannung infolge einer plötzlich auftretenden Überspannung der Strom unschädlich abgeleitet werden kann und die Bauelementstruktur FET nicht schädigt. Eine solche Ableitung kann zwischen den Ein- und Ausgängen des Halbleiterbauelements, zwischen der Versorgungsspannung und einem aus Ein- oder Ausgang oder zwischen einem der genannten Anschlüsse und Masse geschalten werden, um Überspannungen zwischen jeweils zwei beliebigen der genannten Anschlüsse abzuleiten. Möglich ist es auch, in einem Halbleiterbauelement mehrere Zener-Dioden vorzusehen und damit gegebenenfalls alle unabhängigen Anschlüsse sperrend zu überbrücken.

Eine weitere Anwendung ist der bereits erwähnte Einsatz der Zener-Diode als Zener-Fuse, der durch den erfindungsgemäßen Aufbau mit zentralem Kontakt begünstigt ist. Die kontrollierte Einstellung der Zenerspannung erlaubt eine kontrollierte Degradierung zur Schaffung einer niederohmigen Verbindung.

In jedem Fall kann die Zener-Diode Z ohne zusätzliche Masken oder Verfahrensschritte in den BICMOS-Prozessflow integriert werden, da alle erforderlichen Herstellungsschritte auch Teil des Herstellungsverfahrens für Bipolartransistoren und/oder CMOS-Strukturen sind.

## Patentansprüche

1. Halbleiter-Bauelement, umfassend zumindest einen vertikalen Bipolartransistor und eine integrierte Zener-Diode (Z),
- mit einem Halbleiter-Substrat (S)
- mit einem im Halbleiter-Substrat vergrabenen Gebiet (NV), das eine n-Dotierung aufweist
- mit einer zentral angeordneten ersten n-dotierten Zone (NZ1),
- mit einem p-dotierten Gebiet (PG), welches in einem der Oberfläche benachbarten Bereich die erste n-dotierte Zone (NZ1) gegendotiert,
- mit einer zweiten n-dotierten Zone (NZ2), die räumlich von der ersten getrennt, diese und das darüber liegende p-dotierte Gebiet (PG) konzentrisch umschließt und ringförmig ausgebildet ist,
- wobei erste und zweite n-dotierte Zone zwischen dem vergrabenen Gebiet und der Oberfläche des Halbleiter-Substrats angeordnet sind,
- mit einem auf der Oberfläche des Substrats angeordneten ersten Kontakt (A1) zum p-dotierten Gebiet und einem zweiten Kontakt (A2) zur n-dotierten Zone, die die beiden Anschlüsse der Zener-Diode (Z) bilden.

2. Bauelement nach Anspruch 1,
das einen Kollektor mit seitlich zum Bipolartransistor versetzten Kollektoranschluss aufweist, wobei der Kollektoranschluss durch ein weiteres n-dotiertes vergrabenes Gebiet und eine weitere n-dotierte Zone gebildet ist, die von der Dotierungstiefe und Dotierungsstärke her gleich dem n-dotierten vergrabenen Gebiet (NV) und der n-dotierten Zone (NZ) ausgebildet sind.

3. Bauelement nach einem der Ansprüche 1 oder 2,
umfassend zumindest eine CMOS Struktur.

4. Bauelement nach Anspruch 3,
bei dem die CMOS Struktur zumindest einen p-Kanal Transistor mit Source/Drain Gebieten aufweist, die von der Dotierungstiefe und Dotierungsstärke her gleich dem p-dotierten Gebiet (PG) ausgebildet sind.

5. Bauelement nach einem der Ansprüche 1 bis 4,
bei dem die vergrabenen Gebiete (PV) mit Antimon hochdotiert sind.

6. Bauelement nach einem der Ansprüche 1 bis 5,
bei dem das p-dotierte Gebiet (PG) mit Bor hochdotiert ist.

7. Bauelement nach einem der Ansprüche 1 bis 6,
bei dem die erste und die zweite n-dotierte Zone (NZ1, NZ2) mit Phosphor hochdotiert sind.

8. Bauelement nach einem der Ansprüche 1 bis 7,
bei dem die CMOS Struktur zumindest einen Feldeffekttransistor aufweist, zwischen dessen beiden Anschlüssen die Zenerdiode so geschaltet ist, dass sie in Sperrrichtung einen Kurzschluss bildet.

9. Verfahren zur Herstellung eines Halbleiter Bauelements mit einem vertikalen Bipolartransistor, einer CMOS Struktur (FET) und einer integrierten Zener-Diode (Z),
bei dem Bipolartransistor, CMOS Struktur und integrierte Zener-Diode (Z) parallel auf einem Wafer gefertigt werden,
bei dem für die Zener-Diode eine erste n-dotierte Zone (NZ) erzeugt und in einem der Oberfläche benachbarten Bereich gegendotiert wird,
bei dem die n-dotierte Zone zusammen mit der Anschlussdotierung zu einem vergrabenen Gebiet für den elektrischen Anschluss des Kollektors des Bipolartransistors im gleichen Implantationsprozess erzeugt wird,
bei dem Gegendotierung der n-dotierten Zone zusammen mit der Dotierung der Source-/Draingebiete der CMOS Struktur erfolgt.

10. Verfahren nach Anspruch 9,
bei dem ein Halbleiter Substrat (S) mit mehreren n-dotierten vergrabenen Gebieten (NV) hergestellt wird, die als Subkollektorgebiet des Bipolartransistors und zum Anschluss der Anode der Zener-Diode (Z) vorgesehen sind,
bei dem über jedem n-dotierten vergrabenen Gebiet zumindest eine bis zur Oberfläche des Substrats reichende n-dotierte Zone (NZ) ausgebildet und zum Anschluss des vergrabenen Gebiet vorgesehen wird,
bei dem zusammen mit der Strukturierung und Dotierung der Source-/Draingebiete eines p-Kanal MOS Transistors durch Gegendotierung eines der n-dotierten Gebiete (NZ1) in einem der Oberfläche benachbarten Bereich ein p/n-Übergang für die Zener-Diode erzeugt wird.

11. Verfahren nach Anspruch 9 oder 10,
bei dem die n-dotierten Gebiete (NG) mittels einer Hochenergie-Implantation von Phosphor und einen anschließenden thermischen Diffusionsschritt erzeugt werden.

12. Verfahren nach einem der Ansprüche 9 bis 11,
bei dem die Source-/Draingebiete und die Gegendotierung eines der n-dotierten Gebiete (NG1) durch Niederenergie-Implantation von Bor und anschließende thermische Aktivierung der Bordotierung erfolgt.

13. Verfahren nach einem der Ansprüche 9 bis 12,
bei dem das Halbleiter Substrat (S) durch eine oberflächennahe Dotierung eines Wafers mit Antimon und anschließende epitaktische Abscheidung einer Halbleiter Schicht darüber erzeugt wird, wobei aus der zunächst oberflächennahen Antimon Dotierung im Wafer (W) das vergrabene Gebiet (PV) im Substrat (S) entsteht.

14. Verfahren nach einem der Ansprüche 9 bis 13,
bei dem die Dotierung der n-dotierten Zone (NZ) und der p-dotierten Gebiete (PG) kontrolliert bezüglich des Dotierprofils erfolgt und so eine gegebene Zener-Spannung der Zener-Diode (Z) eingestellt wird.

15. Verfahren nach einem der Ansprüche 9 bis 14,
bei dem die Implantationsschritte zur Herstellung der dotierten Zonen und der dotierten Gebiete strukturiert über eine Maske (M) aus aufgewachsenem Oxid erfolgt.

16. Verfahren nach Anspruch 15,
bei dem zur Strukturierung bei der Herstellung der Zener-Diode (Z) eine erste n-dotierte Zone (NZ1) zentral und eine zweite n-dotierte Zone (NZ2) konzentrisch dazu jedoch räumlich getrennt von dieser so angeordnet wird, dass sie die erste n-dotierte Zone ringförmig umschließt und bei dem die Gegendotierung nur in der zentralen ersten n-dotierten n-dotierten Zone erfolgt.

17. Verfahren nach einem der Ansprüche 10 bis 16,
bei dem zur ohm'schen Kontaktierung der Zener-Diode(Z) im Bereich der ringförmigen n-dotierten Zone (NZ2) und im Bereich des zentralen p-dotierten Gebiets (PG) jeweils an der Oberfläche des Substrats Silizid-Kontakte erzeugt werden.

18. Verfahren nach Anspruch 17,
bei dem die ringförmige zweite n-dotierte Zone (NZ2) mit mehreren gleichmäßig verteilten Silizid-Kontakten angeschlossen wird.

19. Verfahren nach-einem der Ansprüche 9 bis 18,
bei dem die Zener-Diode (Z) über metallische Leiter so mit der CMOS Struktur (FET) und dem Bipolartransistor verschaltet wird, dass zumindest eine CMOS Struktur durch die in Sperrrichtung geschaltete Zener-Diode (Z) kurzgeschlossen ist.

## Claims

1. Semiconductor component comprising at least one vertical bipolar transistor and an integrated zener diode (Z),
- having a semiconductor substrate (S)
- having a region (NV) which is buried in the semiconductor substrate and is n-doped,
- having a centrally arranged, first n-doped zone (NZ1),
- having a p-doped region (PG), which has opposite doping to the first n-doped zone (NZ1) in an area adjacent to the surface,
- having a second n-doped zone (NZ2), which, while being physically separated from the first, concentrically surrounds it and the p-doped region (PG) located above it, and has an annular shape,
- with the first and the second n-doped zone being arranged between the buried region and the surface of the semiconductor substrate,
- having a first contact (A1), which is arranged on the surface of the substrate, to the p-doped region, and having a second contact (A2) to the n-doped zone, which contacts form the two connections of the zener diode (Z).

2. Component according to Claim 1,
which has a collector with a collector connection offset laterally with respect to the bipolar transistor, with the collector connection being formed by a further n-doped buried region and by a further n-doped zone which, in terms of the doping depth and the doping strength, are the same as the n-doped buried region (NV) and the n-doped zone (NZ).

3. Component according to one of Claims 1 or 2,
comprising at least one CMOS structure.

4. Component according to Claim 3,
in which the CMOS structure has at least one p-channel transistor with source/drain regions which, in terms of the doping depth and doping strength, are the same as the p-doped region (PG).

5. Component according to one of Claims 1 to 4,
in which the buried region (PV) is heavily doped with antimony.

6. Component according to one of Claims 1 to 5,
in which the buried region (PV) is heavily doped with boron.

7. Component according to one of Claims 1 to 6,
in which the first and the second n-doped zones (NZ1, NZ2) are heavily doped with phosphorus.

8. Component according to one of Claims 1 to 7,
in which the CMOS structure has at least one field-effect transistor, between whose two connections the zener diode is connected such that it forms a short-circuit in the reverse-biased direction.

9. Method for production of a semiconductor component having a vertical bipolar transistor, a CMOS structure (FET) and an integrated zener diode (Z),
in which the bipolar transistor, the CMOS structure and the integrated zener diode (Z) are manufactured parallel on the wafer,
in which a first n-doped zone (NZ) is produced for the zener diode and has opposite doping in an area adjacent to the surface,
in which the n-doped zone is produced together with the connection doping to form a buried region for the electrical connection of the collector of the bipolar transistor, in the same implantation process, and
in which the opposite doping of the n-doped zone is produced together with the doping of the source/drain regions of the CMOS structure.

10. Method according to Claim 9,
in which a semiconductor substrate (S) having a
plurality of n-doped buried regions (NV) is produced, which are provided as a sub-collector region of the bipolar transistor and for connection of the anode of the zener diode (Z),
in which at least one n-doped zone (NZ) is formed over each n-doped buried region, extends to the surface of the substrate and is intended for connection of the buried region, and
in which a pn junction for the zener diode is produced together with the structuring and doping of the source/drain regions of a p-channel MOS transistor by opposite doping of one of the n-doped regions (NZ1) in an area adjacent to the surface.

11. Method according to Claim 9 or 10,
in which the n-doped regions (NG) are produced by means of high-energy implantation of phosphorus, followed by a thermal diffusion step.

12. Method according to one of Claims 9 to 11,
in which the source/drain regions and the opposite doping of one of the n-doped regions (NG1) are produced by low-energy implantation of boron, followed by thermal activation of the boron doping.

13. Method according to one of Claims 9 to 12,
in which the semiconductor substrate (S) is produced by doping, close to the surface, of a wafer with antimony followed by epitaxial deposition of a semiconductor layer above it, with the buried region (PV) being produced in the substrate (S) from the initial doping with antimony close to the surface.

14. Method according to one of Claims 9 to 13,
in which the doping of the n-doped zone (NZ) and of the p-doped regions (PG) is carried out with the doping profile being monitored, so that the zener diode (Z) has a given zener voltage.

15. Method according to one of Claims 9 to 14,
in which the implantation steps for production of the doped zones and of the doped regions are carried in a structured manner, using a mask (M) composed of oxide grown on it.

16. Method according to Claim 15,
in which, for the structuring process during the production of the zener diode (Z), a first n-doped zone (NZ1) is arranged centrally, and a second n-doped zone (NZ2) is arranged concentrically with respect to it, but physically separated from it such that it surrounds the first n-doped zone in an annular shape, and in which the opposite doping is produced only in the central, first n-doped zone.

17. Method according to one of Claims 10 to 16,
in which silicide contacts are in each case produced on the surface of the substrate in order to make a resistive contact with the zener diode (Z) in the area of the annular n-doped zone (NZ2) and in the area of the central p-doped region (PG).

18. Method according to Claim 17,
in which the annular n-doped zone (NZ2) is connected by means of a plurality of uniformly distributed silicide contacts.

19. Method according to one of Claims 9 to 18,
in which the zener diode (Z) is connected via metallic conductors to the CMOS structure (FET) and to the bipolar transistor in such a way that at least one CMOS structure is short-circuited by the reverse biased zener diode (Z).

## Revendications

1. Composant à semi-conducteurs comprenant au moins un transistor bipolaire vertical et une diode Zener (Z) intégrée,
- ayant un substrat (S) semi-conducteur ;
- ayant une région (NV) qui est enterrée dans le substrat semi-conducteur et qui a un dopage n ;
- ayant une première zone (NZ1) dopée n disposée de façon centrale ;
- ayant une région (PG) dopée p qui, dans une partie voisine de la surface, contredope la première zone (NZ1) dopée n ;
- ayant une deuxième zone (NZ2) dopée n qui est séparée dans l'espace de la première, qui entoure concentriquement celle-ci et la région (PG) dopée p se trouvant au-dessus et qui est constituée annulairement ;
- dans lequel la première et la deuxième zones dopées n sont disposées entre la région enterrée et la surface du substrat semi-conducteur ;
- ayant un premier contact (A1) disposé sur la surface du substrat et allant à la région dopée p et un deuxième contact (A2) allant à la zone dopée n qui forment les deux bornes de la diode Zener (Z).

2. Composant suivant la revendication 1,
qui a un collecteur ayant une borne de collecteur décalée latéralement par rapport au transistor bipolaire, la borne de collecteur étant formée par une autre région enterrée et dopée n et par une autre zone dopée n qui, du point de vue de la profondeur de dopage et de l'intensité de dopage, sont constituées de la même façon que la région (NV) enterrée et dopée n et la zone (NZ) dopée n.

3. Composant suivant l'une des revendications 1 ou 2,
comprenant au moins une structure CMOS.

4. Composant suivant la revendication 3,
dans lequel la structure CMOS a au moins un transistor à canal p ayant des régions de source/drain qui, du point de la profondeur de dopage et de l'intensité de dopage, sont constituées de la même façon que la région (PG) dopé p.

5. Composant suivant l'une des revendications 1 à 4,
dans lequel les régions (PV) enterrées sont dopées fortement par de l'antimoine.

6. Composant suivant l'une des revendications 1 à 5,
dans lequel la région (PG) dopé p est dopée fortement par du bore.

7. Composant suivant l'une des revendications 1 à 6,
dans lequel la première et la deuxième zones (NZ1, NZ2) dopées n sont dopées fortement par du phosphore.

8. Composant suivant l'une des revendications 1 à 7,
dans lequel la structure CMOS a au moins un transistor à effet de champ entre les deux bornes duquel la diode Zener est montée de façon à former un court-circuit dans le sens de blocage.

9. Procédé de production d'un composant à semi-conducteurs comprenant un transistor bipolaire vertical, une structure (FET) CMOS et une diode Zener intégrée,
dans lequel on fabrique le transistor bipolaire, la structure CMOS et la diode Zener (Z) intégrée en parallèle sur une tranche,
dans lequel on produit pour la diode Zener une première zone (NZ) dopée n et on la contredope dans une partie voisine de la surface,
dans lequel on produit la zone dopée n, ensemble avec le dopage de connexion à une partie enterrée pour la borne électrique du collecteur du transistor bipolaire, dans la même opération d'implantation,
dans lequel on effectue le contredopage de la zone dopée n, ensemble avec le dopage des parties de source/drain de la structure CMOS.

10. Procédé suivant la revendication 9,
dans lequel on produit un substrat (S) semi-conducteur ayant plusieurs parties (NV) enterrées dopées n qui sont prévues comme parties de sous-collecteur du transistor bipolaire et pour la connexion de l'anode de la diode Zener (Z),
dans lequel on forme sur chaque partie enterrée dopée n au moins une zone (NZ) dopée n allant jusqu'à la surface du substrat et on la prévoit pour la connexion de la partie enterrée,
dans lequel on produit, ensemble avec la structuration et le dopage des parties de source/drain d'un transistor MOS à canal p par contredopage de l'une des parties (NZ1) dopées n, une jonction p/n pour la diode Zener dans une région voisine de la surface.

11. Procédé suivant la revendication 9 ou 10,
dans lequel on produit les parties (NG) dopées n au moyen d'une implantation à haute énergie de phosphore et d'un stade venant ensuite de diffusion thermique.

12. Procédé suivant l'une des revendications 9 à 11,
dans lequel on produit les parties de source/drain et le contredopage de l'une des parties (NG1) dopée n par implantation à basse énergie de bore et par activation thermique venant ensuite du dopage au bore.

13. Procédé suivant l'une des revendications 9 à 12,
dans lequel on produit le substrat (S) semi-conducteur par un dopage proche de la surface d'une tranche par de l'antimoine et ensuite par un dépôt épitaxiale d'une couche semi-conductrice au-dessus, la partie (PV) enterrée du substrat (S) étant créée à partir du dopage par l'antimoine d'abord proche de la surface de la tranche (W).

14. Procédé suivant l'une des revendications 9 à 13,
dans lequel on effectue le dopage de la zone (NZ) dopée n et des parties (PG) dopées p de façon contrôlée pour ce qui concerne le profil de dopage et on règle ainsi une tension (ZR) donnée de la diode Zener (Z).

15. Procédé suivant l'une des revendications 9 à 14,
dans lequel on effectue les stades d'implantation pour la production des zones dopées et des parties dopées de façon structurée par un masque (M) en un oxyde que l'on a fait croître.

16. Procédé suivant la revendication 15,
dans lequel, pour la structuration lors de la production de la diode Zener (Z), on dispose une première zone (NZ1) dopée n de manière centrale et une deuxième zone (NZ2) dopée n concentriquement à celle-ci mais en en étant séparée dans l'espace de manière à ce qu'elle entoure annulairement la première zone dopée n et dans lequel on effectue le contredopage seulement dans la première zone centrale dopée n.

17. Procédé suivant l'une des revendications 10 à 16,
dans lequel, pour la mise en contact ohmique de la diode Zener (Z), on produit dans la région de la zone (NZ2) dopée n annulaire et dans la région de la partie (PG) dopée p centrale, respectivement, des contacts de siliciure à la surface du substrat.

18. Procédé suivant la revendication 17,
dans lequel on raccorde la deuxième zone (NZ2) dopée n annulaire à plusieurs contacts de siliciure répartis uniformément.

19. Procédé suivant l'une des revendications 9 à 18,
dans lequel on monte la diode Zener (Z) par des conducteurs métalliques avec la structure (FET) CMOS et le transistor bipolaire de façon à ce qu'au moins une structure CMOS soit court-circuitée par la diode Zener (Z) montée dans le sens de blocage.
